# EUROPEAN PATENT APPLICATION

(11) **EP 2 466 656 A2**
(43) Date of publication of application: **20.06.2012**
(21) Application number: 11193770.2
(22) Date of filing: 15.12.2011
(51) Int. Cl.: H01L 33/48, F21K 99/00

(54) **Movable light emitting diode device and method for fabricating the same**

(30) Priority: 17.12.2010 KR 20100129851
(71) Applicant: Samsung LED Co., Ltd., Yongi-city, Gyeonggi-Do 446-711 (KR)
(72) Inventor: Kim, Young Shin, 134-777 Seoul (KR); Cho, Young Jin, 100-727 Seoul (KR); Lee, Jae Hee, 150-753 Seoul (KR); Kim, Hae Chul, 442-762 Gyeonggi-do (KR)
(74) Representative: Grünecker, Kinkeldey, Stockmair & Schwanhäusser

(57) **Abstract**

Provided is a light emitting diode, LED device (100). The LED device (100) may include an LED (120), a body (140) on which the LED (120) is fixed and a coil (150) is wound, and a magnet (160) that is located at a predetermined distance from the coil (150), on at least one side of the body (140), and that provides a magnetic force to the coil (150), and the body (140) may move in a predetermined direction when a voltage is provided to the coil (150).

## Description

### CROSS-REFERENCE TO RELATED APPLICATION

This application claims the priority benefit of Korean Patent Application No. 10-2010-0129851, filed on December 17, 2010, in the Korean Intellectual Property Office, the disclosure of which is incorporated herein by reference.

### BACKGROUND

### 1. Field

Example embodiments relate to a moveable light emitting diode (LED) device and a manufacturing method thereof, which may be applicable to various fields that provide predetermined effects by moving a light source, such as a projector, a stage lighting, a mood lamp, and the like.

### 2. Description of the Related Art

Recently, many countries have adopted the green growth model with producing low carbon emissions as their industrial growth model.

Accordingly, the lighting field should be adapted according to the trend of the green growth model.

Electric energy consumed by lighting accounts for about 19 % of the total amount of electric energy consumed in the world and thus, when current lighting devices are replaced with high-efficiency lighting devices, about 70 % to 80 % of the current energy consumption may be reduced.

Therefore, a light emitting diode (LED) that reduces the energy consumption and the emission of carbon has drawn attention.

When the LED was begun to be used as lighting, the LED was merely regarded as a light source that emitted light, conversely, the LED is now used in various fields of lighting.

The LED may effectively control illuminance and color temperature, may provide higher phototransformation efficiency than a light bulb or a fluorescent lamp, and may have a relatively long lifespan and thus, a scope of application may increase.

Recently, an LED that uses a compound semiconductor material, for example, GaAs, GaN, AlGaInP, and the like, has been developed and thus, a varied color emitting source may be embodied.

Various structures obtained by combining LEDs may be used in various fields, such as an indoor and outdoor lighting device, a car headlight, a courtesy light, a back light unit of a liquid crystal display (LCD), and the like, and the LED may become popular since the LED is an eco-friendly product.

### SUMMARY

The foregoing and/or other aspects are achieved by providing a light emitting diode (LED) device, including an LED, a body on which the LED is fixed and a coil is wound, and a magnet located at a predetermined distance, from the coil on at least one side of the body, and providing a magnetic force to the coil, and the body moves in a predetermined direction when a voltage is provided to the coil.

The foregoing and/or other aspects are achieved by providing an LED device manufacturing method, the method including forming an LED, forming a body on which a coil is wound, and fixing the body on the LED, forming a magnet being located at a predetermined distance, from the coil on at least one side of body, and providing a magnetic force to the coil, and the body is movable in a predetermined direction when a voltage is provided to the coil.

Additional aspects of embodiments will be set forth in part in the description which follows and, in part, will be apparent from the description, or may be learned by practice of the disclosure.

### EFFECT

Example embodiments may include a moveable light emitting diode (LED) and thus, may provide a distinctive light source in various fields where a conventional LED is used.

Example embodiments may include a moveable LED and thus, may provide a predetermined effect generated by moving a light source, such as a projector, a stage lighting, a mood lamp, and the like.

Example embodiments may include an outer metal side and thus, may promptly emit heat generated from an inside and may effectively shield against electro-magnetic interference (EMI) generated from an outside environment.

Example embodiments may include an LED wrapped with a metal side and thus, the metal side may replace a conventional heat sink and a volume of the LED may significantly decrease.

### BRIEF DESCRIPTION OF THE DRAWINGS

These and/or other aspects will become apparent and more readily appreciated from the following description of embodiments, taken in conjunction with the accompanying drawings of which:
FIGS. 1A and 1B illustrate a cross-section of a light emitting diode (LED) device according to example embodiments;
FIG. 2 illustrates a solid side of the LED device of FIG. 1 according to example embodiments;
FIG. 3 illustrates a solid side of an LED device including a metal side according to example embodiments; and
FIGS. 4A through 6 illustrate an LED device manufacturing method according to example embodiments.

### DETAILED DESCRIPTION

Reference will now be made in detail to embodiments, examples of which are illustrated in the accompanying drawings, wherein like reference numerals refer to the like elements throughout. Embodiments are described below to explain the present disclosure by referring to the figures.

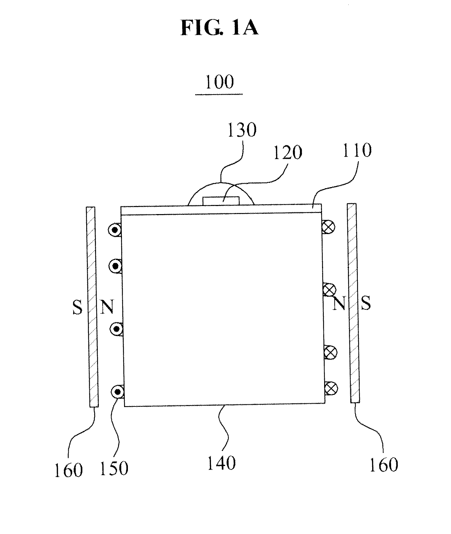

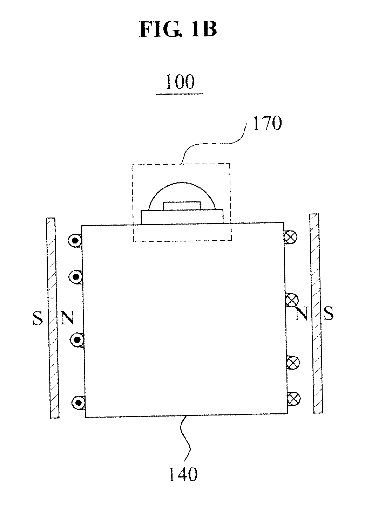

FIGS. 1A and 1B illustrate a cross-section of a light emitting diode (LED) device 100 according to example embodiments.

Referring to FIG. 1A, the LED device 100 may include a substrate 110, an LED chip 120, a resin molding 130, a body 140, a coil 150, and a magnet 160.

The LED chip 120 may be mounted on the substrate 110. In this example, the LED chip 120 may be mounted based on a wire-bonding scheme, a flip-chip scheme, and the like. The resin molding 130 may protect the LED chip 120, and may be formed in a shape of a convex lens and the like.

The substrate 110 may include materials, for example, a ceramic, a printed circuit board (PCB), a flame resistant- 4 (FR4), and a metal, and the like.

The body 140 may be fixed on the substrate 110. In this example, the body 140 may be wound by a coil 150 that is made of high conductometric material.

The magnet 160 may be located at a predetermined distance from the coil 150, on at least one side of the body 140.

In this example, the magnet 160 may provide a magnetic force to the coil 150.

A magnetic force generated by the magnet 160 and an electric force generated by the core 150 may transfer kinetic energy to the body 140 based on the Fleming left-hand rule.

According to the Fleming left-hand rule, electric energy in a conducting wire may be converted to the kinetic energy in a magnetic field. In this example, the coil 150 may perform as the conducting wire and the magnet 160 may perform as the magnetic field.

The kinetic energy may be transferred to the body 140 based on a principle of an electric motor, a motor, and the like that performs a rotary motion with electric energy.

Through a current induced in the coil due to a voltage difference, the kinetic energy may be transferred to the substrate 110 fixed on the body 140, and the LED chip 120 mounted on the substrate 110 may be moved by the kinetic energy.

Referring to FIG. 1B, the LED device 100 may be formed to include an LED package 170 that is directly fixed on the body 140.

The LED package 170 may include an LED chip, a resin molding, a reflector, and the like.

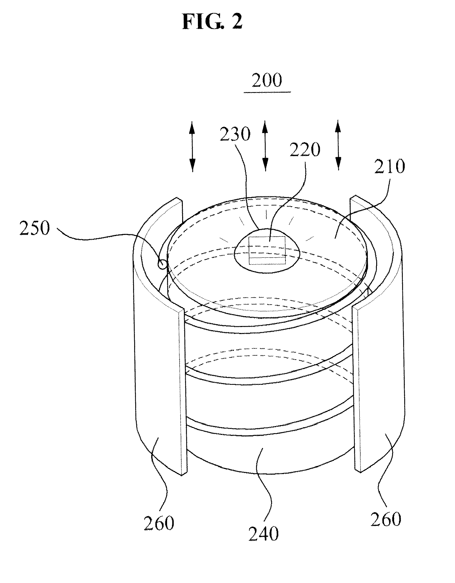

The LED device 100 will be described with reference to FIG. 2.

FIG. 2 illustrates a solid side of an LED device 200 according to example embodiments.

Referring to FIG. 2, the LED device 200 may include a substrate 210, an LED chip 220, a resin molding 230, a body 240, a coil 250, and a magnet 260.

For another example, the LED device 200 may be embodied to include an LED package that is connected to the body 240, as illustrated in FIG. 1B.

As illustrated in FIG. 2, the body 240 may be formed in a shape of a cylinder.

The body 240 may be formed in the shape of the cylinder to move up and down by the kinetic energy.

Even though the body 240 is formed in the shape of the cylinder throughout the example embodiments, the body 240 may be formed in various forms.

The coil 250 may be formed in a form that wraps, in a spiral, around an outer side of the body 240 formed in the shape of the cylinder.

The coil 250 may supply, to the LED chip 220, a provided anode voltage and a provided cathode voltage.

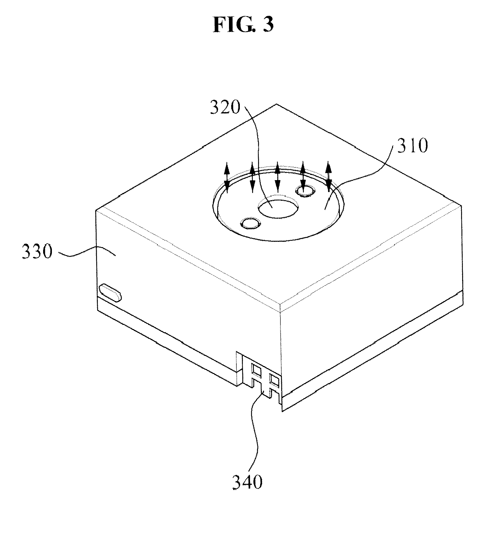

FIG. 3 illustrates a solid side of an LED device including a metal side according to example embodiments.

The LED device may perform shielding an outer side of a magnet with the metal side 330.

In the LED device that is shielded by the metal device 330, a body 310 and an LED 320 fixed on the body 310 may move up and down by kinetic energy.

The metal side 330 may emit, to an outside environment, heat generated from the LED 320, or may shield against electro-magnetic interference (EMI) generated from the outside environment.

For example, the metal side 330 may emit the heat generated from the LED 320, to the outside environment using a heat sink, a heat radiating tape, and the like.

An anode voltage and a cathode voltage of a coil may be supplied to the coil by connecting a lead frame (L/F) 340 to a flexible printed circuit board (FPCB). When a substrate is a ceramic, an LED PKG voltage may be supplied to the coil by connecting a pad for a bottom side to the substrate, based on a surface mount technology (SMT). In the same manner, the L/F 340 may be connected to the substrate. The voltage supplied to the coil may be used as a driving voltage of the LED 320.

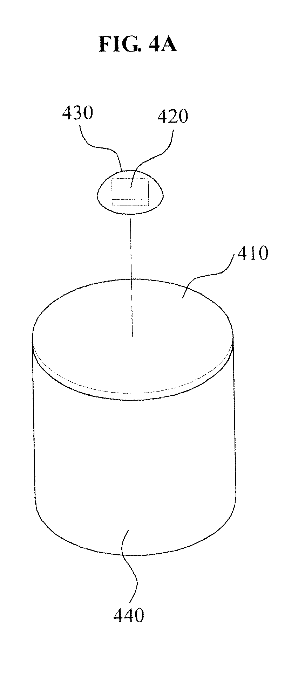

FIGS. 4A through 6 illustrate an LED device manufacturing method according to example embodiments.

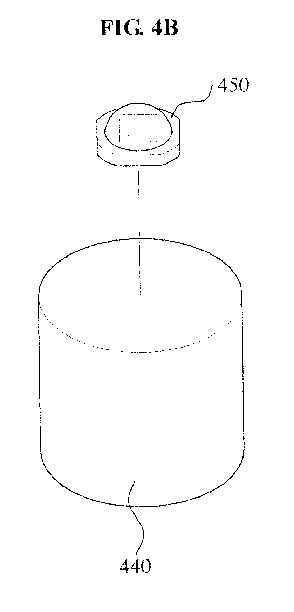

Referring to FIGS. 4A and 4B, the LED device manufacturing method may form an LED.

Referring to FIG. 4A, the LED device manufacturing method may form an LED chip 420 and may mount the formed LED chip 420 on a substrate 410 to form the LED device.

Referring to FIG. 4B, the LED device manufacturing method may form the LED by forming an LED package 450. The LED package 450 may receive voltage from the coil that is combined with the body 440 in a spiral by soldering the coil and the body 440 together, as opposed to exposing an L/F to an outside to receive the voltage.

The LED device manufacturing method may fix the formed LED on the body 440. Even though the LED device manufacturing method is described using the LED of FIG. 4A, it may also be applicable to the LED of FIG. 4B.

According to an example embodiment, the body 440 may be fixed on the substrate 420, in any form that enables a movement of the body 440 to be transferred to the substrate 420.

In this example, the LED chip may be protected by a resin molding 430.

The LED device manufacturing method may mount the formed LED chip on the substrate 420 based on at least one of a flip-chip bonding scheme and a wire-bonding scheme.

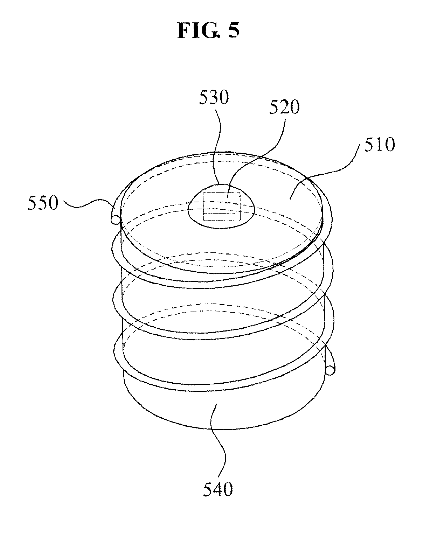

Referring to FIG. 5, the LED device manufacturing method may form, in a spiral, a coil 550 on a body 540, on which a substrate 510, an LED chip 520, and a resin molding 530 are fixed.

An anode voltage and a cathode voltage may be provided to the coil 550 and may flow via the coil 550 that is formed in a spiral.

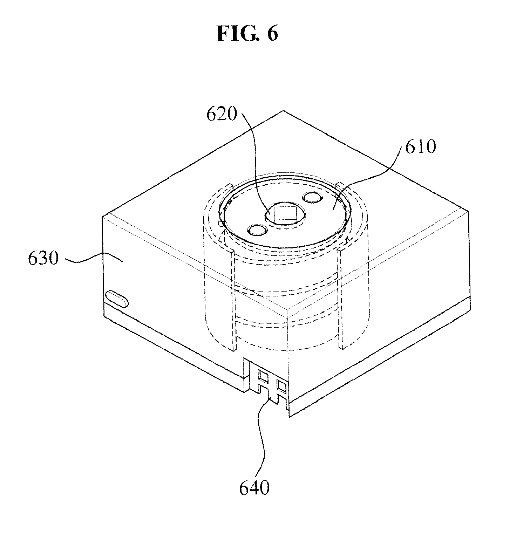

Referring to FIG. 6, the LED device manufacturing method may form a magnet on at least one side of a body 610, on which an LED chip 620 is fixed, and the magnet may provide a magnetic force to a coil. In this example, the magnet may be located at a predetermined distance from the coil.

The magnet may be formed at the predetermined distance from the coil, on the body 610, to reduce a resistance to a movement of the coil and the fixed body 610, the resistance being generated by a reaction between the magnet and the coil.

The LED device manufacturing method may form an outer metal side 630. The outer metal side 630 may emit heat generated from an inside and may effectively shield EMI generated from an outside environment.

A voltage supplied to the coil may be transferred via an L/F 640 formed on one side of the outer metal side 630.

When the voltage is provided to the coil, the body 610 may move in a predetermined direction.

An LED device formed, based on the LED device manufacturing method, may move a location of the LED device and thus, may provide a distinctive light source in various fields where a conventional LED is used.

In addition, an LED device formed based on the LED device manufacturing method may move a fixed LED device and thus, may provide a predetermined effect generated by moving a light source, such as a projector, a stage lighting, a mood lamp, and the like.

According to the LED device formed, based on the LED device manufacturing method, may be designed to promptly emit heat generated from an inside through an outer metal side, to effectively shield against EMI generated from an outside environment, and to be wrapped with a metal side and thus, the metal side may replace a conventional heat sink and a volume of the LED device may significantly decrease.

Although embodiments have been shown and described, it would be appreciated by those skilled in the art that changes may be made in these embodiments without departing from the principles and spirit of the disclosure, the scope of which is defined by the claims and their equivalents.

## Claims

1. A light emitting diode (LED) device, comprising:
an LED;
a body on which the LED is fixed and a coil is wound; and
a magnet located at a predetermined distance from the coil on at least one side of the body, and providing a magnetic force to the coil,
wherein the body moves in a predetermined direction when a voltage is provided to the coil.

2. The LED device of claim 1, wherein the LED is an LED package.

3. The LED device of claim 1, wherein the LED comprises:
an LED chip; and
a substrate containing the LED chip.

4. The LED device of claim 1, wherein the body is formed in a shape of a cylinder, and the magnet is formed in a shape that wraps around an outer side of the body.

5. The LED device of claim 1, wherein the coil supplies, to the LED, a provided anode voltage and a provided cathode voltage.

6. The LED device of claim 3, wherein the substrate comprises at least one of a ceramic, a printed circuit board (PCB), a flame resistant-4 (FR4), and a metal.

7. The LED device of claim 3, wherein the LED chip is mounted on the substrate based on at least one of a flip-chip bonding scheme and a wire-bonding scheme.

8. The LED device of claim 1, further comprising:
a metal side being formed on an outer side of the magnet.

9. The LED device of claim 8, wherein the metal side emits, to an outside environment, heat generated from the LED chip.

10. The LED device of claim 8, wherein the metal side shields against electro-magnetic interference (EMI) generated from an outside environment.

11. A method of manufacturing a light emitting diode (LED) device, the method comprising:
forming an LED;
forming a body on which a coil is wound, and fixing the body on the LED;
forming a magnet being located at a predetermined distance from the coil, on at least one side of body, and providing a magnetic force to the coil,
wherein the body is movable in a predetermined direction when a voltage is provided to the coil.

12. The method of claim 11, wherein the forming of the LED comprises:
forming an LED package.

13. The method of claim 11, wherein:
the forming of the LED comprises forming an LED chip, and mounting the formed LED chip on a substrate; and
the fixing of the body on the LED comprises fixing the substrate on the formed body.

14. The method of claim 13, wherein the mounting of the LED chip on the substrate comprises:
mounting the LED chip on the substrate based on at least one of a flip-chip bonding scheme and a wire-bonding scheme.

15. The method of claim 13, further comprising:
forming a metal side that is formed on an outer side of the magnet,
wherein the metal side emits, to an outside environment, heat generated from the LED chip, or shields against electro-magnetic interference (EMI) generated from the outside environment.
